# EUROPÄISCHE PATENTANMELDUNG

(11) **EP 4 279 206 A1**
(43) Veröffentlichungstag der Anmeldung: **22.11.2023**
(21) Anmeldenummer: 22173898.2
(22) Anmeldetag: 17.05.2022
(51) Int. Cl.: B23C 5/10, B23B 27/00, B23B 51/00, B23D 77/00, B23K 26/36

(54) **SCHNEIDWERKZEUG UND VERFAHREN ZUR HERSTELLUNG EINES SCHNEIDWERKZEUGS**

(71) Anmelder: Rollomatic S.A., 2525 Le Landeron (CH)
(72) Erfinder: KRUMM, Christian, 2607 Cortébert (CH); MOUREAUX, Carole, 25500 Morteau (FR); SAILLARD, Thibaut, 25000 Besançon (FR)
(74) Vertreter: Geitz Patentanwälte PartG mbB

(57) **Zusammenfassung**

Es werden ein Schneidwerkzeug und ein Verfahren zur Herstellung eines Schneidwerkzeugs vorgeschlagen. Das Schneidwerkzeug ist ausgestattet mit einem Werkzeugkörper (1), der mit einer Hartbeschichtung (2) ausgestattet ist, und mindestens eine geschärfte Schneidkante (10, 14) aufweist, welche zwischen einer Freifläche (5) und einer Spanfläche (6) verläuft. Dabei gilt für einen Winkel δ zwischen einer ersten geometrischen Ebene (16, 36), in welcher die unter der Hartbeschichtung (2) der Freifläche (5) liegende Oberfläche (9) des Werkzeugkörpers (1) verläuft, und einer zweiten geometrischen Ebene (18, 38), in welcher eine durch die geschärfte Schneidkante (10, 14) begrenzte Oberfläche (8, 28) der Hartbeschichtung (2) im Bereich der Freifläche (5, 25) verläuft: 1° ≤ δ ≤ 70. Das Schneidwerkzeug wird durch einen entsprechenden Materialabtrag der Hartbeschichtung an der Freifläche (5) hergestellt.

## Beschreibung

Die Erfindung geht aus von einem Schneidwerkzeug mit mindestens einer Schneidkante, wobei das Schneidwerkzeug einen Werkzeugkörper aufweist, der mit einer Hartbeschichtung zumindest im Bereich der Schneidkante ausgestattet ist. Ferner geht die Erfindung aus von einem Verfahren zur Herstellung eines derartigen Schneidwerkzeugs.

Schneidwerkzeuge umfassen Zerspanungswerkzeuge für spanabhebende Fertigungsverfahren und Werkzeuge für das Zerteilen. Sie weisen in der Regel einen Schaft und einen Schneidteil auf. Dabei dient der Schaft dem Halten des Schneidwerkzeugs, beispielsweise in einer Maschinenschnittstelle bei Maschinenbearbeitungswerkzeugen. An dem Schaft ist der Schneidteil angeordnet. Dieser weist mindestens eine Schneidkante auf, mit der das Schneidwerkzeug in Wechselwirkung mit einem zu bearbeitenden Werkstück tritt und dabei von dem Werkstück Material abträgt. Zu derartigen Schneidwerkzeugen zählen beispielweise Fräser, Bohrer, Reibahlen, Meißel, Schaber, Hobel und Sägen. Dabei kann das Schneidwerkzeug ein Massiv-Werkzeug sein, welches durchgängig aus einem einzigen Material besteht. Alternativ dazu kann das Schneidteil auch einen die Schneidkante umfassenden Einsatz aufweisen, wobei der Einsatz aus einem anderen Material besteht als der Schaft. Schneidwerkzeuge unterliegen an ihrem Einsatzort aufgrund der auf sie wirkenden Kräfte und der entstehenden Temperaturen erheblichen mechanischen und thermischen Belastungen. Hierzu zählen mechanische Reibung, Oxidation und Abrieb sowie vor allem bei hohen Bearbeitungsgeschwindigkeiten Diffusion und Verzunderung. Dies führt zu einem Verschleiß des Schneidwerkzeugs im Bereich der Schneidkante.

Um die Verschleißfestigkeit von Schneidwerkzeugen zu verbessern und die Standzeit zu erhöhen, werden Schneidwerkzeuge im Bereich der Schneidkante mit einer Hartbeschichtung ausgestattet. Diese wird auf den Werkzeugkörper aufgebracht. Zu derartigen Hartbeschichtungen zählen beispielsweise Diamantbeschichtungen, amorphe Kohlenstoffschichten, die in der englischen Sprache als Diamond like Carbon DLC bezeichnet werden, und Titanbeschichtungen. Diese werden beispielsweise mittels chemischer Gasphasenabscheidung, englisch Chemical Vapour Deposition, CVD auf den Werkzeugkörper aufgebracht. Nach dem Abscheiden der Hartbeschichtung weist die beschichtete Schneidkante eine stumpfe Rundung auf. Diese muss anschließend geschärft werden, damit die Schneidkante einen gewünschten Kantenradius aufweist. Hierzu wird ein Teil der Hartbeschichtung im Bereich der Schneidkante abgetragen. Das Schärfen einer Schneidkante durch Abtragen eines Teils des harten Materials an der Oberfläche des Schneidwerkzeugs kann beispielsweise mittels einer Laserbearbeitungsmaschine durchgeführt werden. Der Materialabtrag wird auch als Laserablation oder Laserverdampfen bezeichnet. Das Material kann beispielsweise flächig in Schichten abgetragen werden. Dabei ist der Laserstrahl im wesentlichen senkrecht zu der Fläche ausgerichtet, an der ein Teil der Hartbeschichtung abgetragen wird. Hierbei kann es sich um die Freifläche oder die Spanfläche handeln. Ein derartiges Verfahren ist beispielsweise aus der DE 10 2009 004 316 A1 und aus der DE 10 2011 076 584 A1 bekannt. Ferner besteht die Möglichkeit, ein Teil der Hartbeschichtung mittels kontinuierlicher oder gepulster Laserstrahlung abzutrennen, wobei der Laserstrahl im wesentlichen parallel zu der zu erzeugenden Oberfläche ausgerichtet ist. Ein derartiges Verfahren ist beispielsweise aus der EP 2 682 219 A1 bekannt. Dabei kann der Laserstrahl derart auf das zu bearbeitende Schneidwerkzeug gerichtet werden, dass der Materialabtrag im Bereich der zu erzeugenden Schneidkante beginnt, wie dies in Figur 1 der EP 2 682 219 A1 dargestellt ist. Dies wird auch als Materialabtrag von vorne bezeichnet. Alternativ dazu kann der Materialabtrag auch an der Seite des Schneidwerkzeugs beginnen, die der zu erzeugenden Schneidkante abgewandt ist, wie dies in Figur 3 der EP 2 682 219 A1 dargestellt ist. Dies wird auch als Materialabtrag von hinten bezeichnet. Die Parameter der Laserstrahlung müssen an das zu bearbeitende Material und die gewünschte Bearbeitung angepasst werden. Der Materialabtrag kann an der Freifläche, an der Spanfläche oder an beiden Flächen erfolgen.

Das Schärfen der beschichteten Schneidkante erfolgt in der Regel derart, dass der Keilwinkel des durch die Freifläche und die Spanfläche gebildeten Schneidkeils des unbeschichteten Werkzeugkörpers mit dem Keilwinkel des beschichteten und nachgeschärften Schneidkeils übereinstimmt. Dieses Vorgehen weist jedoch den Nachteil auf, bei einer Ausrichtung des Laserstrahls parallel zu der zu erzeugenden Oberfläche und einem Materialabtrag von hinten der Laserstrahl in unerwünschter Weise an einer sekundären Freifläche oder einer sonstigen Oberfläche des Schneidwerkzeugs abgelenkt werden kann, die weder der Freifläche noch der Spanfläche entspricht. Eine derartige Ablenkung des Laserstrahls kann dazu führen, dass die Laserbearbeitung nicht zu dem angestrebten Schärfen der Schneidkante führt.

Der Erfindung liegt die Aufgabe zugrunde, ein hartbeschichtetes Schneidwerkzeug und ein Verfahren zur Herstellung eines hartbeschichteten Schneidwerkzeugs zur Verfügung zu stellen, bei dem ein vorgegebener Kantenradius der beschichteten Schneidkante auch dann in zuverlässiger Weise erzielt werden kann, wenn zum Schärfen der beschichteten Schneidkante ein Teil der Hartbeschichtung mittels eines Laserstrahls abgetragen wird, wobei der Laserstrahl nicht senkrecht zu der zu erzeugenden Oberfläche des Schneidwerkzeugs ausgerichtet ist und der Materialabtrag auch von hinten erfolgen kann.

Diese Aufgabe wird durch ein Schneidwerkzeug mit den Merkmalen des Anspruchs 1 und durch ein Verfahren zur Herstellung eines Schneidwerkzeugs mit den Merkmalen des Anspruchs 12 gelöst. Das Schneidwerkzeug zeichnet sich dadurch aus, dass die Oberfläche der Hartbeschichtung im Bereich der Freifläche nach dem teilweisen Materialabtrag nicht parallel zu der darunterliegenden Oberfläche des Werkzeugkörpers ist, sondern dass eine erste geometrische Ebene, in welcher die unter der Hartbeschichtung der Freifläche liegende Oberfläche des Werkzeugkörpers verläuft, und eine zweite geometrische Ebene, in welcher eine durch die geschärfte Schneidkante begrenzte Oberfläche der Hartbeschichtung im Bereich der Freifläche verläuft, einen Winkel δ einschließen, für den gilt: 1° ≤ δ ≤ 70. Dabei wird berücksichtigt, dass die unter der Beschichtung an der Freifläche liegende Oberfläche des Werkzeugkörpers an der unbeschichteten Schneidkante endet, während sich die geometrische Ebene, in der diese Oberfläche des Werkzeugkörpers verläuft, unendlich weit erstreckt. Die Oberfläche der Hartbeschichtung im Bereich der Freifläche nach dem teilweisen Materialabtrag endet an der geschärften Schneidkante, während sich die zweite geometrische Ebene unendlich weit erstreckt. Die erste geometrische Ebene und die zweite geometrische Ebene schneiden sich entlang einer geometrischen Geraden. Diese geometrische Gerade kann
- mit der unbeschichteten Schneidkante des Werkzeugkörpers zusammenfallen,
- mit der geschärften Schneidkante des Schneidwerkzeugs zusammenfallen,
- außerhalb des Werkzeugkörpers und innerhalb der Hartbeschichtung an der Spanfläche verlaufen, oder
- außerhalb des Schneidwerkzeugs verlaufen.

Die Oberfläche der Hartbeschichtung im Bereich der Freifläche bevorzugt derart geneigt, dass die Schichtdicke der Hartbeschichtung an der Freifläche ausgehend von der Schneidkante mit zunehmender Entfernung von der Schneidkante zunimmt. Wenn eine Hartbeschichtung mit einheitlicher Schichtdicke an der Schneidkante, der Freifläche und der Spanfläche abgeschieden wird, muss beim anschließenden Nachschärfen der Schneidkante nur unmittelbar an der Schneidkante ein gewisser Materialabtrag erfolgen. Die Menge des abzutragenden Materials der Hartbeschichtung nimmt mit zunehmender Entfernung von der Schneidkante ab. Dadurch wird eine Schneidkante mit vorgegebenem Kantenradius erzeugt und es verbleibt gleichzeitig mehr Material der Hartbeschichtung an dem Schneidwerkzeug. Da weniger Material entfernt werden muss, erfolgt der Materialabtrag in einer kürzeren Zeit.

Der Materialabtrag der Hartbeschichtung erfolgt bevorzugt mittels eines Laserstrahls. Dieser kann unter dem Winkel δ relativ zu der Oberfläche der Hartbeschichtung an der Freifläche ausgerichtet werden, um die Hartbeschichtung teilweise zu entfernen. Der Abtrag der Hartbeschichtung kann dabei insbesondere von hinten erfolgen. Das heißt, dass der Abtrag in einem der zu erzeugenden scharfen Schneidkante abgewandten Abschnitt der Freifläche beginnt. Dadurch wird eine unerwünschte Ablenkung des Laserstrahls vermieden. Es wird eine geschärfte Schneidkante mit einem vorgegebenen Kantenradius in der gewünschten Qualität erzeugt.

Nach einer vorteilhaften Ausgestaltung der Erfindung gilt für den Winkel δ:
2° ≤ δ ≤ 10°, bevorzugt 3° ≤ δ ≤ 6°. Der Winkel δ hängt typischerweise von der Schichtdicke der Hartbeschichtung an der Freifläche, vom Material der Hartbeschichtung und von dem Keilwinkel des Schneidkeils ab.

Nach einer weiteren vorteilhaften Ausgestaltung der Erfindung gilt für den Winkel δ: 30° ≤ δ ≤ 70°. Ein derartiger Bereich für den Winkel δ ist beispielsweise von Vorteil, wenn sich die erste geometrische Ebene und die zweite geometrische Ebene entlang einer geometrischen Geraden schneiden, die mit der unbeschichteten Schneidkante des Werkzeugkörpers zusammenfällt. Die unbeschichtete Schneidkante wird dadurch freigelegt. Dadurch werden mechanische oder thermische Spannungen zwischen Werkzeugkörper und Hartbeschichtung vermieden.

Nach einer weiteren vorteilhaften Ausgestaltung der Erfindung nimmt die Dicke der Hartbeschichtung an der Freifläche ausgehend von der geschärften Schneidkante mit zunehmender Entfernung von der geschärften Schneidkante zu.

Nach einer weiteren vorteilhaften Ausgestaltung der Erfindung schneiden sich die erste geometrische Ebene und die zweite geometrische Ebene an der unbeschichteten Schneidkante. In diesem Fall ist der Werkzeugkörper im Bereich der unbeschichteten Schneidkante von der Hartbeschichtung befreit. Hierdurch können mechanische oder thermische Spannungen zwischen dem Werkzeugkörper und der Hartbeschichtung vermieden werden.

Nach einer weiteren vorteilhaften Ausgestaltung der Erfindung gilt für einen Winkel ε zwischen einer dritten geometrischen Ebene, in welcher die unter der Hartbeschichtung der Spanfläche liegende Oberfläche des Werkzeugkörpers verläuft, und einer vierten Ebene, in welcher eine durch die geschärfte Schneidkante begrenzten Oberfläche der Hartbeschichtung im Bereich der Spanfläche (6) verläuft: 0° ≤ ε ≤ 70°.In diesem Fall wird zum Nachschärfen der Schneidkante nach dem Abscheiden der Hartbeschichtung nicht nur die Schichtdicke der Hartbeschichtung an der Freifläche reduziert, sondern auch an der Spanfläche. Dabei kann der Materialabtrag derart erfolgen, dass die nach dem Materialabtrag neu gebildete Oberfläche parallel zu der darunter liegenden Oberfläche des Werkzeugkörpers ist, also ε=0°, oder mit dieser Oberfläche einen von 0° verschiedenen Winkel einschließt. Ist letzteres erfüllt, so wird genau wie an der Freifläche die Schichtdicke an der Spanfläche bevorzugt derart reduziert, dass die Schichtdicke der Hartbeschichtung ausgehend von der Schneidkante mit zunehmendem Abstand von der Schneidkante zunimmt.

Nach einer weiteren vorteilhaften Ausgestaltung der Erfindung gilt für den Winkel ε: 2° ≤ ε ≤ 10°, bevorzugt 3° ≤ ε ≤ 6°.

Nach einer weiteren vorteilhaften Ausgestaltung der Erfindung sind der Winkel δ und der Winkel ε gleich groß.

Nach einer weiteren vorteilhaften Ausgestaltung der Erfindung sind der Winkel ε vom Winkel δ verschieden.

Nach einer weiteren vorteilhaften Ausgestaltung der Erfindung nimmt die Dicke der Hartbeschichtung an der Spanfläche ausgehend von der geschärften Schneidkante mit zunehmender Entfernung von der geschärften Schneidkante zu.

Nach einer weiteren vorteilhaften Ausgestaltung der Erfindung ist die Hartbeschichtung an der Spanfläche zumindest abschnittsweise vollständig entfernt. Dies bedeutet, dass der Werkzeugkörper im Bereich der Spanfläche freigelegt ist. Insbesondere ist der Werkzeugkörper an oder nahe der Schneidkante von der Hartbeschichtung befreit. Hierdurch können mechanische oder thermische Spannungen zwischen Werkzeugkörper und Hartbeschichtung vermieden oder zumindest reduziert werden.

Nach einer weiteren vorteilhaften Ausgestaltung der Erfindung ist die Hartbeschichtung eine Diamantbeschichtung. Unter diese Art der Diamantbeschichtung fallen kristalline Diamantschichten und polykristalline Diamantschichten. Letztere haben eine heterogene Verteilung der Größe der kristallinen Domänen. Darüber hinaus sind auch Hartbeschichtungen aus anderen Materialien möglich, beispielsweise Beschichtungen auf der Basis von Nitrid wie Titannitrid, oder sonstige für Hartbeschichtungen geeignete Materialien.

Nach einer weiteren vorteilhaften Ausgestaltung der Erfindung besteht die Hartbeschichtung aus DLC Diamond like Carbon. Diese Art der Hartbeschichtung wird auch als amorpher Diamant bezeichnet.

Nach einer weiteren vorteilhaften Ausgestaltung der Erfindung weist die Hartbeschichtung Titan auf.

Nach einer weiteren vorteilhaften Ausgestaltung der Erfindung besteht der Werkzeugkörper aus Karbid.

Nach einer weiteren vorteilhaften Ausgestaltung der Erfindung beträgt die Schichtdicke der Hartbeschichtung im Bereich der Freifläche und der Spanfläche der Schneidkante, in der kein Materialabtrag erfolgt ist, zwischen 2 und 40µm.

Das erfindungsgemäße Verfahren zur Herstellung des Schneidwerkzeugs zeichnet sich dadurch aus, dass nach dem Abscheiden der Hartbeschichtung die Schneidkante nachgeschärft wird, indem an der Freifläche die Hartbeschichtung teilweise abgetragen wird, derart, dass eine erste geometrische Ebene, in welcher die unter der Hartbeschichtung der Freifläche liegende Oberfläche des Werkzeugkörpers verläuft, mit einer zweiten geometrischen Ebene, in der die durch die geschärfte Schneidkante begrenzte Oberfläche der Hartbeschichtung an der Freifläche nach dem Materialabtrag verläuft, einen Winkel δ einschließt, für den gilt: 1° ≤ δ ≤ 70°.

Nach einer weiteren vorteilhaften Ausgestaltung der Erfindung wird auf dem Werkzeugkörper eine Hartbeschichtung mit einer Schichtdicke zwischen 2 µm und 40 µm abgeschieden.

Nach einer weiteren vorteilhaften Ausgestaltung der Erfindung erfolgt das Abtragen der Hartbeschichtung derart, dass für den Winkel δ gilt: 2° ≤ δ ≤ 10°, besonders bevorzugt 3° ≤ δ ≤ 6°.

Nach einer weiteren vorteilhaften Ausgestaltung der Erfindung wird bei dem teilweisen Abtrag der Hartbeschichtung die Dicke der Hartbeschichtung an der Freifläche derart reduziert, dass die Dicke der Hartbeschichtung ausgehend von der geschärften Schneidkante mit zunehmender Entfernung von der geschärften Schneidkante zunimmt.

Nach einer weiteren vorteilhaften Ausgestaltung der Erfindung erfolgt das teilweise Abtragen der Hartbeschichtung mittels Laserbearbeitung.

Nach einer weiteren vorteilhaften Ausgestaltung der Erfindung wird bei der Laserbearbeitung ein Laserstrahl mit seiner Strahlachse derart ausgerichtet, dass er mit der ersten geometrischen Ebene den Winkel δ einschließt.

Nach einer weiteren vorteilhaften Ausgestaltung der Erfindung beginnt der Materialabtrag der Hartbeschichtung an der Freifläche der Hartbeschichtung in einem der Schneidkante entfernten Abschnitt der Freifläche und endet an der Spanfläche. Es findet in diesem Fall ein Materialabtrag von hinten statt.

Nach einer weiteren vorteilhaften Ausgestaltung der Erfindung wird die mit der Hartbeschichtung ausgestattete Schneidkante durch zusätzliches teilweises Abtragen der Hartbeschichtung im Bereich der Spanfläche geschärft, derart, dass nach dem teilweisen Abtragen der Hartbeschichtung für einen Winkel ε zwischen einer dritten geometrischen Ebene, in welcher die unter der Hartbeschichtung der Spanfläche liegende Oberfläche des Werkzeugkörpers verläuft, und einer vierten geometrischen Ebene, in welcher die durch die geschärfte Schneidkante begrenzte Oberfläche der Hartbeschichtung im Bereich der Spanfläche nach dem teilweisen Materialabtrag verläuft, gilt: 0° ≤ ε ≤ 70°. Dabei kann der Winkel δ mit dem Winkel ε hinsichtlich der Größe übereinstimmen oder von diesem verschieden sein.

Nach einer weiteren vorteilhaften Ausgestaltung der Erfindung erfolgt das Abtragen der Hartbeschichtung an der Spanfläche derart, dass für den Winkel ε gilt: 2° ≤ ε ≤ 10°, besonders bevorzugt 3° ≤ ε ≤ 6°.

Nach einer weiteren vorteilhaften Ausgestaltung der Erfindung wird bei dem teilweisen Abtrag der Hartbeschichtung die Dicke der Hartbeschichtung an der Spanfläche derart reduziert, dass die Dicke der Hartbeschichtung an der Spanfläche ausgehend von der geschärften Schneidkante mit zunehmender Entfernung von der Schneidkante zunimmt.

Nach einer weiteren vorteilhaften Ausgestaltung der Erfindung wird als Hartbeschichtung eine Diamantschicht an dem Werkzeugkörper abgeschieden. Dabei kann es sich um eine kristalline oder polykristalline Diamantschicht handeln. Anstelle von Diamant kann auch eine Hartbeschichtung aus DLC, aus einen Nitrid-basierten Material, einem Titan enthaltenden Material oder einem anderen für eine Hartbeschichtung geeigneten Material auf den Werkzeugkörper aufgetragen werden.

Nach einer weiteren vorteilhaften Ausgestaltung der Erfindung wird die Hartbeschichtung an der Freifläche zumindest abschnittweise derart vollständig entfernt, dass der Werkzeugkörper in dem betreffenden Abschnitt freigelegt ist. Dies gilt insbesondere für die unbeschichtete Schneidkante des Werkzeugkörpers und gegebenenfalls einen hierzu benachbarten Bereich.

Nach einer weiteren vorteilhaften Ausgestaltung der Erfindung wird die Hartbeschichtung an der Spanfläche zumindest abschnittsweise derart vollständig entfernt, dass der Werkzeugkörper in dem betreffenden Abschnitt freigelegt ist. Bevorzugt wird der Werkzeugkörper im Bereich der unbeschichteten Schneidkante des Werkzeugkörpers freigelegt.

Weitere Vorteile und vorteilhafte Ausgestaltungen der Erfindung sind der nachfolgenden Beschreibung, der Zeichnung und den Ansprüchen entnehmbar.

### Zeichnung

In der Zeichnung ist ein Ausführungsbeispiel der Erfindung dargestellt. Es zeigen:
- Figur 1: Schneidwerkzeug ohne Hartbeschichtung in perspektivischer Darstellung,
- Figur 2: Ausschnitt aus dem Schneidwerkzeug gemäß Figur 1,
- Figur 3: Schneidwerkzeug gemäß Figur 1 in perspektivischer Darstellung unmittelbar nach dem Auftrag einer Hartbeschichtung und vor dem Schärfen der Schneidkante,
- Figur 4: Ausschnitt aus dem Schneidwerkzeug gemäß Figur 3,
- Figur 5: Schnitt durch das Schneidwerkzeug gemäß Figur 3 im Bereich einer Schneidkante,
- Figur 6: Schnitt gemäß Figur 5, wobei die Hartbeschichtung an der Freifläche der Schneidkante teilweise entfernt ist,
- Figur 7: Darstellung gemäß Figur 6 mit dem Winkel δ,
- Figur 8: Schnitt durch das Schneidwerkzeug gemäß Figur 3 und 5, wobei die Hartbeschichtung an der Freifläche und an der Spanfläche der Schneidkante teilweise entfernt ist,
- Figur 9: Schneidwerkzeug gemäß Figur 3, wobei die Hartbeschichtung an der Freifläche und an der Spanfläche der Schneidkante gemäß Figur 8 entfernt ist,
- Figur 10: Ausschnitt aus dem Schneidwerkzeug gemäß Figur 9,
- Figur 11: Darstellung der Ausrichtungen eines Laserstrahls beim Materialabtrag bei dem Schneidwerkzeug gemäß Figuren 6 bis 10,
- Figur 12: weitere Schneidkante des Schneidwerkzeugs gemäß Figur 3,
- Figur 13: Darstellung einer alternativen Ausrichtung eines Laserstrahls beim Materialabtrag bei dem Schneidwerkzeug gemäß Figuren 6 bis 10.

### Beschreibung des Ausführungsbeispiels

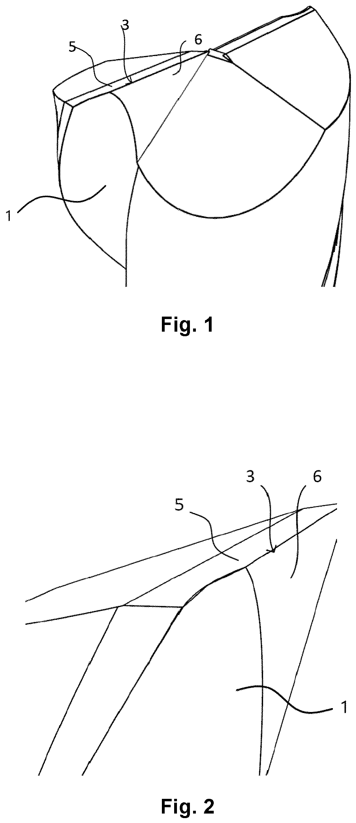

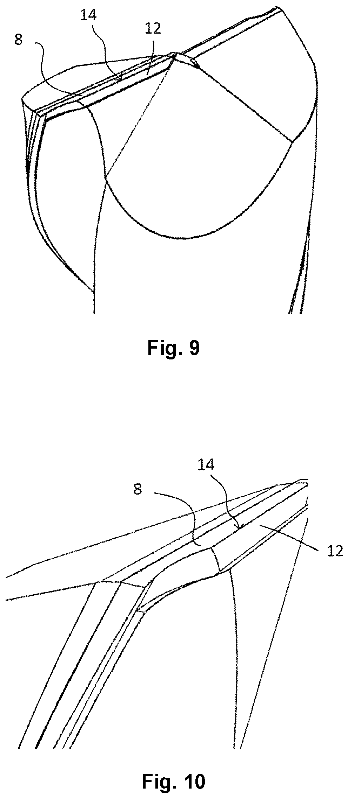

In den Figuren 1 bis 10 ist ein Schneidwerkzeug zu verschiedenen Zeitpunkten seiner Herstellung dargestellt. Bei dem Schneidwerkzeug handelt es sich um einen Vierkant-Schaftfräser. Figuren 1 und 2 zeigen den Werkzeugkörper 1 des Schneidwerkzeugs ohne Hartbeschichtung. Der Werkzeugkörper weist eine Schneidkante 3 mit einer zugehörige Freifläche 5 und einer zugehörigen Spanfläche 6 auf.

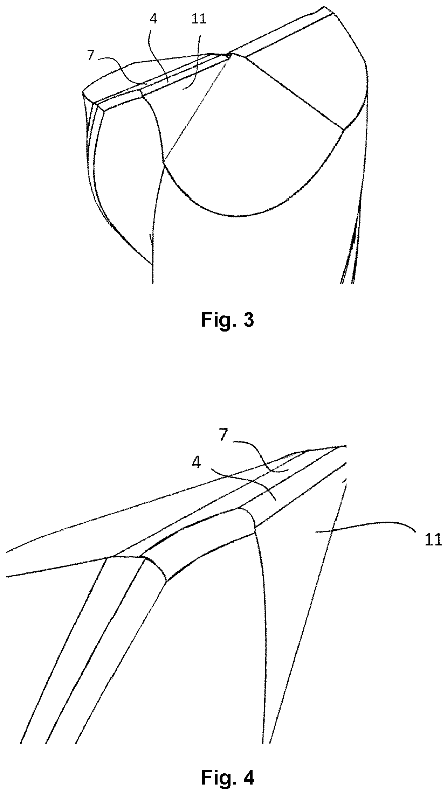

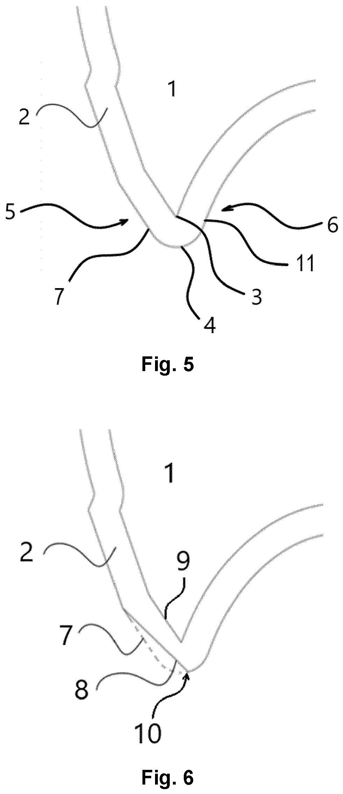

Die Figuren 3, 4 und 5 zeigen das Schneidwerkzeug nach dem Auftrag einer Hartbeschichtung 2 auf den Werkzeugkörper 1. Die Hartbeschichtung erstreckt sich über die gesamte in Figur 1 dargestellte Oberfläche des Werkzeugkörpers 1. Durch den Auftrag der Hartbeschichtung hat sich über der unbeschichteten Schneidkante 3 des Werkzeugkörpers 1 eine stumpfe Rundung 4 ausgebildet. Benachbart zu der stumpfen Rundung 4 befinden sich die Oberfläche 7 der Hartbeschichtung 2 an der Freifläche 5 und die Oberfläche 11 der Hartbeschichtung an der Spanfläche 6. Die Hartbeschichtung 2 weist in dem in Figur 5 dargestellten Abschnitt eine gleichmäßige Schichtdicke auf.

Figur 5 zeigt, dass der Kantenradius der stumpfen Rundung 4 größer ist als der Kantenradius der Schneidkante 3 des unbeschichteten Werkzeugkörpers 1. Um den Kantenradius der beschichteten Schneidkante zu reduzieren, wird die Schneidkante nach dem Beschichten geschärft, indem die Hartbeschichtung 2 teilweise abgetragen wird.

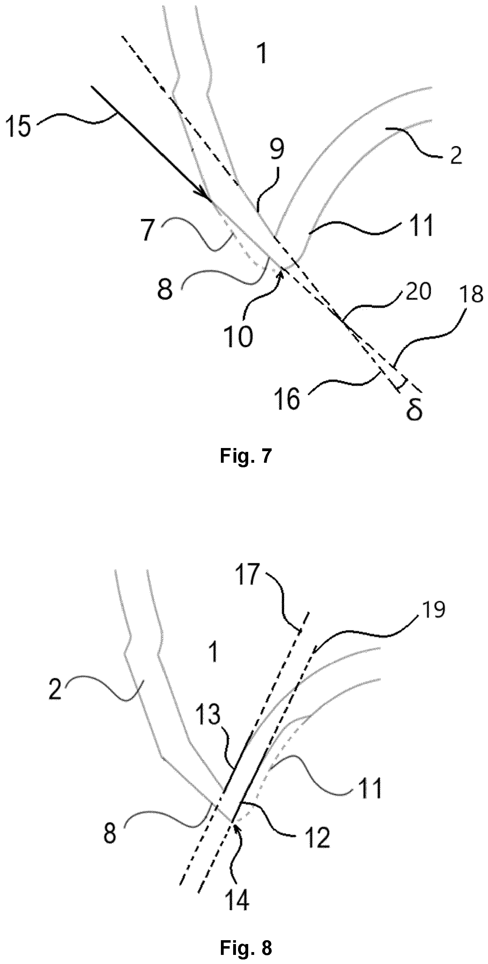

Der Abtrag der Hartbeschichtung ist in den Figuren 6 bis 10 dargestellt. Zuerst wird, wie in Figur 6 und 7 gezeigt, ein Teil der Hartbeschichtung an der Freifläche entfernt, während die Spanfläche zunächst noch unverändert ist. Hierzu wird ein Laserstrahl mit seiner Strahlachse 15 derart ausgerichtet, dass die Strahlachse mit einer ersten geometrischen Ebene 16 den Winkel δ einschließt. In dieser ersten geometrischen Ebene 16 verläuft die Oberfläche 9 des Werkzeugkörpers 1 unter der Hartbeschichtung an der Freifläche 5. Diese Oberfläche 9 des Werkzeugkörpers 1 wird durch die Schneidkante 3 des unbeschichteten Werkzeugkörpers 1 begrenzt. Sie ist benachbart zu der Beschichtung 2. Die erste geometrische Ebene ist nicht begrenzt. Sie erstreckt sich über die Oberfläche 9 der Werkzeugkörpers 1 hinaus. Der ursprüngliche Verlauf 7 der Oberfläche der Hartbeschichtung 2 an der Freifläche ist gestrichelt dargestellt. Durch den teilweisen Materialabtrag ist eine neue Oberfläche 8 der Hartbeschichtung an der Freifläche entstanden. Diese Oberfläche 8 verläuft in einer zweiten geometrischen Ebene 18. Die erste geometrische Ebene 16 und die zweite geometrische Ebene 18 sind nicht parallel einander. Sie schneiden sich in einer geometrischen Geraden 20, von der aufgrund der Blickrichtung in Figur 7 nur ein Punkt erkennbar ist. Die geometrische Gerade 20 verläuft außerhalb des Schneidwerkzeugs. Die erste geometrische Ebene 16 und die zweite geometrische Ebene 18 schließen den Winkel δ ein. Im vorliegenden Ausführungsbeispiel beträgt der Winkel δ 10°. Der Winkel δ ist in Figur 7 dargestellt. Durch den teilweisen Materialabtrag an der Freifläche entsteht eine neue geschärfte Schneidkante 10. Figur 7 zeigt, dass der Laserstrahl mit seiner Strahlachse 15 im wesentlichen parallel zu der zweiten geometrischen Ebene 18 ausgerichtet ist, in der die durch Materialabtrag an der Freifläche erzeugte Oberfläche 8 der Hartbeschichtung verläuft. Figur 7 zeigt ferner, dass der Materialabtrag in einem der Schneidkante abgewandten Abschnitt der Freifläche beginnt und sich entlang der zweiten geometrischen Ebene 18 bis zur Spanfläche fortsetzt.

Die Figuren 8, 9 und 10 zeigen das Schneidwerkzeug, nachdem zusätzlich an der Spanfläche ein Teil der Hartbeschichtung 2 entfernt wurde. Der ursprüngliche Verlauf 11 der Oberfläche der Hartbeschichtung an der Spanfläche ist in Figur 8 gestrichelt dargestellt. Durch den teilweisen Materialabtrag ist eine neue Oberfläche 12 der Hartbeschichtung an der Spanfläche entstanden. Diese Oberfläche 12 ist parallel zu der darunter liegenden Oberfläche 13 des Werkzeugkörpers 1. Die Oberfläche 13 verläuft in einer dritten geometrischen Ebene 17. Die Oberfläche 12 verläuft in einer vierten geometrischen Ebene 19. Der Winkel ε zwischen den beiden Oberflächen 12 und 13 ist dabei 0°. Entsprechend ist der Winkel ε zwischen der dritten geometrischen Ebene 17 und der vierten geometrischen Ebene 19 ebenfalls 0°. Die dritte geometrische Ebene 17 und die vierte geometrische Ebene schneiden sich nicht. Durch den teilweisen Materialabtrag an der Spanfläche ist eine neue geschärte Schneidkante 14 entstanden.

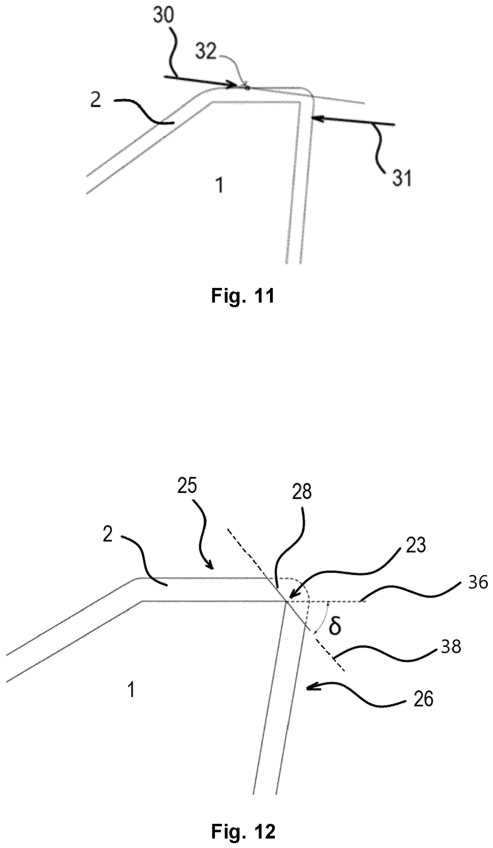

Figur 11 zeigt wie der Laserstrahl mit seiner Strahlachse beim Materialabtrag an der Freifläche und an der Spanfläche ausgerichtet ist. Die erste Ausrichtung der Strahlachse 30 ist beim Materialabtrag an der Freifläche gegeben. Sie entspricht im wesentlichen der Ausrichtung der Strahlachse 15 des Laserstrahls in Figur 7. Der Laserstrahl trifft an dem Punkt 32 auf die Oberfläche der Hartbeschichtung 2 des Werkzeugkörpers 1. Der Materialabtrag beginnt in einem der Schneidkante abgewandten Abschnitt der Freifläche und endet an der Spanfläche. Beim Materialabtrag der Hartbeschichtung an der Spanfläche weist die Strahlachse 31 des Laserstrahls eine Ausrichtung auf, die im wesentlichen senkrecht zu der Oberfläche der Hartbeschichtung 2 ist oder maximal um einen Winkel von 10° gegen eine Senkrechte zur Oberfläche der Hartbeschichtung geneigt ist.

Figur 12 zeigt den Materialabtrag an einer weiteren Schneidkante 23 des Schneidwerkzeugs gemäß Figur 3. Dabei wird die Hartbeschichtung 2 an dem Werkzeugkörper 1 ausgehend von der Freifläche 25 derart bis zur Spanfläche 26 abgetragen, dass eine neue Oberfläche 28 der Hartbeschichtung an der Freifläche entsteht. Diese neue Oberfläche 28 verläuft in einer zweiten geometrischen Ebene 38. Die Oberfläche des Werkzeugkörpers 1, welche sich unter der Hartbeschichtung 2 an der Freifläche 25 befindet, verläuft in einer ersten geometrischen Ebene 36. Die erste geometrische Ebene 36 und die zweite geometrische Ebene 38 schneiden sich unter dem Winkel δ in der Schneidkante 23 des Werkzeugkörpers 1. Im vorliegenden Fall ist der Winkel δ 50°. Durch den Materialabtrag und die dabei erzeugte neue Oberfläche 28 wird die Hartbeschichtung an der Schneidkante 23 des Werkzeugkörpers 1 entfernt, so dass die Schneidkante 23 frei von einer Hartbeschichtung ist.

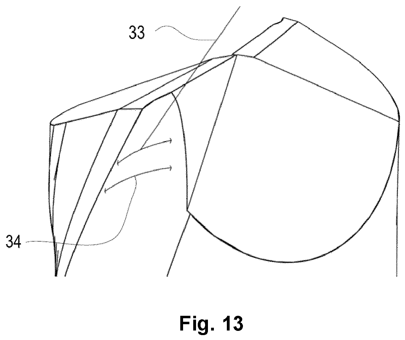

Figur 13 zeigt eine weitere Möglichkeit, wie der Laserstrahl mit seiner Strahlachse 33 relativ zu dem Schneidwerkzeug beim Materialabtrag an der Spanfläche ausgerichtet sein kann. Die Strahlachse 33 ist unter Berücksichtigung einer Abweichung von ±10° parallel zum Steigungswinkel des schraubenförmigen Schneidwerkzeugs ausgerichtet. Dargestellt ist ferner, wie das Schneidwerkzeug relativ zu dem Laserstrahl während des Materialabtrags bewegt wird.

Sämtliche Merkmale der Erfindung können sowohl einzeln als auch in beliebiger Kombination miteinander erfindungswesentlich sein.

### Bezugszahlen

- 1: Werkzeugkörper
- 2: Hartbeschichtung
- 3: Schneidkante des Werkzeugkörpers
- 4: Stumpfe Rundung
- 5: Freifläche
- 6: Spanfläche
- 7: Ursprünglicher Verlauf der Oberfläche der Hartbeschichtung an der Freifläche
- 8: Verlauf der Oberfläche der Hartbeschichtung an der Freifläche nach dem teilweisen Materialabtrag
- 9: Oberfläche des Werkzeugkörpers an der Freifläche
- 10: nachgeschärfte beschichtete Schneidkante
- 11: Ursprünglicher Verlauf der Oberfläche der Hartbeschichtung an der Spanfläche
- 12: Verlauf der Oberfläche der Hartbeschichtung an der Spanfläche nach dem teilweisen Materialabtrag
- 13: Oberfläche des Werkzeugkörpers an der Spanfläche
- 14: nachgeschärfte beschichtete Schneidkante
- 15: Strahlachse eines Laserstrahls
- 16: erste geometrische Ebene
- 17: dritte geometrische Ebene
- 18: zweite geometrische Ebene
- 19: vierte geometrische Ebene
- 20: geometrische Gerade, in der sich die erste und die zweite geometrische Ebene schneiden
- 22: Hartbeschichtung
- 23: Schneidkante des Werkzeugkörpers
- 25: Freifläche
- 26: Spanfläche
- 28: Verlauf der Oberfläche der Hartbeschichtung an der Freifläche nach dem teilweisen Materialabtrag
- 30: erste Ausrichtung der Strahlachse des Laserstrahls
- 31: zweite Ausrichtung der Strahlachse des Laserstrahls
- 32: Auftreffpunkt des Laserstrahls auf die Oberfläche der Hartbeschichtung
- 33: dritte Ausrichtung der Strahlachse des Laserstrahls
- 34: Relativbewegung des Schneidwerkzeugs
- 36: erste geometrische Ebene
- 38: zweite geometrische Ebene

## Patentansprüche

1. Schneidwerkzeug
mit einem Werkzeugkörper (1), der mit einer Hartbeschichtung (2) ausgestattet ist,
mit mindestens einer geschärften Schneidkante (10, 14), welche zwischen einer Freifläche (5) und einer Spanfläche (6) verläuft,
wobei die Hartbeschichtung (2) zumindest im Bereich der geschärften Schneidkante (10, 14), der Freifläche (5, 25) und der Spanfläche (6, 26) auf den Werkzeugkörper (1) aufgebracht ist,
wobei für einen Winkel δ zwischen einer ersten geometrischen Ebene (16, 36), in welcher die unter der Hartbeschichtung (2) der Freifläche (5) liegende Oberfläche (9) des Werkzeugkörpers (1) verläuft, und einer zweiten geometrischen Ebene (18, 38), in welcher eine durch die geschärfte Schneidkante (10, 14) begrenzte Oberfläche (8, 28) der Hartbeschichtung (2) im Bereich der Freifläche (5, 25) verläuft, gilt: 1° ≤ δ ≤ 70.

2. Schneidwerkzeug gemäß Anspruch 1, **dadurch gekennzeichnet, dass** für den Winkel δ gilt: 2° ≤ δ ≤ 10°, bevorzugt 3° ≤ δ ≤ 6°.

3. Schneidwerkzeug nach Anspruch 1 oder 2, **dadurch gekennzeichnet, dass** die Dicke der Hartbeschichtung (2) an der Freifläche (5, 25) ausgehend von der geschärften Schneidkante (10, 14) mit zunehmender Entfernung von der geschärften Schneidkante (10, 14) zunimmt.

4. Schneidwerkzeug gemäß Anspruch 1, 2 oder 3, **dadurch gekennzeichnet, dass** die durch die geschärfte Schneidkante (10, 14) begrenzte Oberfläche (8, 28) der Hartbeschichtung (2) im Bereich der Freifläche (5, 25) die darunter liegende Oberfläche (9) des Werkzeugkörpers (1) an der unbeschichteten Schneidkante (3, 23) des Werkzeugkörpers (1) schneidet.

5. Schneidwerkzeug nach einem der vorhergehenden Ansprüche, **dadurch gekennzeichnet, dass** für einen Winkel ε zwischen einer dritten geometrischen Ebene (17), in welcher die unter der Hartbeschichtung (2) der Spanfläche (6) liegende Oberfläche (9) des Werkzeugkörpers (1) verläuft, und einer vierten Ebene (19), in welcher eine durch die geschärfte Schneidkante (14) begrenzten Oberfläche (12) der Hartbeschichtung (2) im Bereich der Spanfläche (6) verläuft, gilt: 0° ≤ ε ≤ 70°.

6. Schneidwerkzeug nach Anspruch 5, **dadurch gekennzeichnet, dass** für den Winkel ε gilt: 2° ≤ ε ≤ 10°, bevorzugt 3° ≤ ε ≤ 6°.

7. Schneidwerkzeug nach Anspruch 5 oder 6, **dadurch gekennzeichnet, dass** der Winkel δ und der Winkel ε gleich groß sind.

8. Schneidwerkzeug nach Anspruch 5 oder 6, **dadurch gekennzeichnet, dass** der Winkel ε vom Winkel δ verschieden ist.

9. Schneidwerkzeug nach einem der Ansprüche 5 bis 8, **dadurch gekennzeichnet, dass** die Dicke der Hartbeschichtung (2) an der Spanfläche (6) ausgehend von der geschärften Schneidkante (14) mit zunehmender Entfernung von der geschärften Schneidkante (14) zunimmt.

10. Schneidwerkzeug nach einem der vorhergehenden Ansprüche, **dadurch gekennzeichnet, dass** die Hartbeschichtung (2) an der Spanfläche (6) zumindest abschnittsweise vollständig entfernt ist.

11. Schneidwerkzeug nach einem der vorhergehenden Ansprüche, **dadurch gekennzeichnet, dass** die Hartbeschichtung (2) eine Diamantbeschichtung ist.

12. Verfahren zur Herstellung eines Schneidwerkzeugs nach einem der vorhergehenden Ansprüche, **gekennzeichnet durch** folgende Verfahrensschritte:
Abscheiden einer Hartbeschichtung (2) an der Oberfläche des Werkzeugkörpers (1) des Schneidwerkzeugs im Bereich der Schneidkante (3, 23), der zur Schneidkante (3, 23) benachbarten Freifläche (5, 25) und der zur Schneidkante (3, 23) benachbarten Spanfläche (6, 26),
Schärfen der mit der Hartbeschichtung (2) ausgestatteten, eine stumpfe Rundung (4) bildenden Schneidkante durch teilweises Abtragen der Hartbeschichtung (2) im Bereich der Freifläche (5, 25) der Schneidkante, derart, dass für einen Winkel δ zwischen einer ersten geometrischen Ebene (16, 36), in welcher die unter der Hartbeschichtung (2) der Freifläche (5, 25) liegende Oberfläche (9) des Werkzeugkörpers (1) verläuft, und einer zweiten geometrischen Ebene (18, 38), in welcher eine durch die geschärfte Schneidkante (10, 14) begrenzte Oberfläche (8, 28) der Hartbeschichtung (2) im Bereich der Freifläche (5, 25) nach dem Abtragen verläuft, gilt: 1° ≤ δ ≤ 70.

13. Verfahren nach Anspruch 12, **dadurch gekennzeichnet, dass** auf dem Werkzeugkörper (1) eine Hartbeschichtung (2) mit einer Schichtdicke zwischen 2 µm und 40 µm abgeschieden wird.

14. Verfahren nach Anspruch 12 oder 13, **dadurch gekennzeichnet, dass** das Abtragen der Hartbeschichtung (2) derart erfolgt, dass für den Winkel δ gilt: 2° ≤ δ ≤ 10°, besonders bevorzugt 3° ≤ δ ≤ 6°.

15. Verfahren nach einem der Anspruch 12, 13 oder 14, **dadurch gekennzeichnet, dass** bei dem teilweisen Abtrag der Hartbeschichtung (2) die Dicke der Hartbeschichtung (2) an der Freifläche (5, 25) derart reduziert wird, dass die Dicke der Hartbeschichtung (2) ausgehend von der geschärften Schneidkante (10, 14) mit zunehmender Entfernung von der geschärften Schneidkante (10, 14) zunimmt.

16. Verfahren nach Anspruch 12, 13, 14 oder 15, **dadurch gekennzeichnet, dass** das teilweise Abtragen der Hartbeschichtung (2) mittels Laserbearbeitung erfolgt.

17. Verfahren nach Anspruch 16, **dadurch gekennzeichnet, dass** bei der Laserbearbeitung ein Laserstrahl mit seiner Strahlachse (15, 30) derart ausgerichtet wird, dass er mit der ersten geometrischen Ebene (16, 36) den Winkel δ einschließt.

18. Verfahren nach Anspruch 17, **dadurch gekennzeichnet, dass** der Materialabtrag der Hartbeschichtung (2) an der Freifläche (5, 25) der Hartbeschichtung (2) in einem der Schneidkante (3, 23) des Werkzeugkörpers (1) entfernten Abschnitt der Freifläche (5, 25) beginnt und an der Spanfläche (6, 26) endet.

19. Verfahren nach einem der Ansprüche 12 bis 18, **dadurch gekennzeichnet, dass** die mit der Hartbeschichtung (2) ausgestattete Schneidkante (10) durch zusätzliches teilweises Abtragen der Hartbeschichtung (2) im Bereich der Spanfläche (6) geschärft wird, derart, dass nach dem teilweisen Abtragen der Hartbeschichtung (2) für einen Winkel ε zwischen einer dritten geometrischen Ebene (17), in welcher die unter der Hartbeschichtung (2) der Spanfläche (6) liegende Oberfläche (9) des Werkzeugkörpers (1) verläuft, und einer vierten Ebene (19), in welcher eine durch die geschärfte Schneidkante (14) begrenzten Oberfläche (12) der Hartbeschichtung (2) im Bereich der Spanfläche (6) nach dem Abtragen verläuft, gilt: 0° ≤ ε ≤ 70°.

20. Verfahren nach Anspruch 19, **dadurch gekennzeichnet, dass** das Abtragen der Hartbeschichtung (2) derart erfolgt, dass für den Winkel ε gilt: 2° ≤ ε ≤ 10°, besonders bevorzugt 3° ≤ ε ≤ 6°.

21. Verfahren nach Anspruch 19 oder 20, **dadurch gekennzeichnet, dass** bei dem teilweisen Abtrag der Hartbeschichtung (2) die Dicke der Hartbeschichtung (2) an der Spanfläche (6) derart reduziert wird, dass die Dicke der Hartbeschichtung (2) an der Spanfläche (6) ausgehend von der geschärften Schneidkante (14) mit zunehmender Entfernung von der geschärften Schneidkante (14) zunimmt.

22. Verfahren nach einem der Ansprüche 12 bis 21, **dadurch gekennzeichnet, dass** als Hartbeschichtung (2) eine Diamantschicht an dem Werkzeugkörper (1) abgeschieden wird.

23. Verfahren nach einem der Ansprüche 12 bis 22, **dadurch gekennzeichnet, dass** die Hartbeschichtung (2) an der Freifläche (5, 25) zumindest abschnittweise derart vollständig entfernt wird, dass der Werkzeugkörper (1) in dem betreffenden Abschnitt freigelegt ist.

24. Verfahren nach einem der Ansprüche 12 bis 23, **dadurch gekennzeichnet, dass** die Hartbeschichtung (2) an der Spanfläche (6, 26) zumindest abschnittsweise derart vollständig entfernt wird, dass der Werkzeugkörper (1) in dem betreffenden Abschnitt freigelegt ist.
